# EUROPÄISCHE PATENTSCHRIFT

(11) **EP 0 707 293 B1**
(45) Veröffentlichungstag und Bekanntmachung des Hinweises auf die Patenterteilung: **24.11.1999**
(21) Anmeldenummer: 95112622.6
(22) Anmeldetag: 10.08.1995
(51) Int. Cl.: G08B 13/19, H01R 13/66

(54) **Gehäuse für eine Überwachungseinrichtung**
Housing for a surveillance device
Boîtier pour dispositif de surveillance

(30) Priorität: 10.10.1994 DE 9416315 U
(43) Veröffentlichungstag der Anmeldung: 17.04.1996
(73) Patentinhaber: Fritz Fuss GmbH & Co., D-72458 Albstadt (DE)
(72) Erfinder: Künzel, Reiner, D-72336 Balingen-Endingen (DE)
(74) Vertreter: Lang, Friedrich, Dipl.-Ing.

(56) Entgegenhaltungen:
- DE-A- 3 910 653
- GB-A- 2 186 972

## Beschreibung

Die Erfindung betrifft ein Gehäuse für eine Überwachungseinrichtung, bestehend aus einem Gehäuseoberteil und einem lösbar mit dem Gehäuseoberteil verbindbaren Gehäuseunterteil gemäß dem Oberbegriff des Anspruchs 1.

Derartige Überwachungseinrichtungen, z.B. Passiv-Infrarot-Bewegungsmelder, weisen eine elektrische Schaltung sowie Sende- und/oder Empfangseinrichtungen auf. Die elektrische Schaltung ist dabei meist auf dem Gehäuseunterteil angeordnet, während sich die Sende- und/oder Empfangseinrichtungen im oder am Gehäuseoberteil befinden und mittels elektrischer Leitungen mit der elektrischen Schaltung verbunden sind. Diese elektrischen Leitungen können nur bei geöffnetem Gehäuse, z.B. mittels Löten, mit der elektrischen Schaltung und den Sende- und/oder Empfangseinrichtungen verbunden werden, so daß sie eine für die eigentliche Verbindung nicht erforderliche Länge aufweisen müssen. Dies führt nicht nur zu einem höheren Widerstand, sondern auch zu Schwierigkeiten beim Verbinden der beiden Gehäuseteile, z.B. mittels Schrauben, wobei sich die elektrischen Leitungen ungeordnet im Gehäuseinneren befinden. Ist beispielsweise ein wärmeerzeugendes elektrisches Bauteil in der Überwachungseinrichtung vorgesehen, so besteht die Gefahr einer Beschädigung der Isolierung der elektrischen Leitungen. Ebenfalls ist es möglich, daß die elektrischen Leitungen zwischen den beiden Gehäuseteilen eingeklemmt und beim Verbinden der beiden Gehäuseteile beschädigt werden. Die Montage derartiger Gehäuse ist somit zeit- und kostenaufwendig und unsicher.

In der DE-A-3 910 653 ist zwar eine elektrische Steckverbindung zwischen dem Gehäuseoberteil und dem Gehäuseunterteil beschrieben. Die mechanische Verbindung der beiden Gehäuseteile erfolgt dadurch, daß jedes Gehäuseteil Schraubenlöcher aufweist, in welche erst dann eine Schraube eingesteckt und aufgeschraubt werden kann, wenn die elektrische Steckverbindung bereits hergestellt ist. Solange die Schraubenverbindung nicht hergestellt ist, muß die elektrische Steckverbindung alle mechanischen Kräfte aufnehmen, insbesondere die durch das Gewicht des Gehäuseoberteils einschließlich des Infrarot-Melders verursachten Kipp- und Scherkräfte. Es besteht daher die Gefahr, daß die elektrische Steckverbindung Verschleiß ausgesetzt ist, welcher die Kontaktsicherheit beeinträchtigt.

Es ist daher **Aufgabe** der vorliegenden Erfindung, ein Gehäuse der eingangs genannten Art derart weiterzubilden, daß eine sichere und schnelle Verbindung zwischen der im Gehäuseunterteil angeordneten elektrischen Schaltung und den im Gehäuseoberteil angeordneten Sende- und/oder Empfangseinrichtungen ermöglicht wird.

Diese Aufgabe wird durch die im Anspruch 1 gekennzeichnete Erfindung gelöst. Bevorzugte Weiterbildungen sind in abhängigen Ansprüchen beschrieben.

Mit der Erfindung ist es nunmehr möglich, die elektrischen Leitungen auf die unmittelbar erforderliche Länge zu beschränken, wobei eine planmäßige Anordnung der elektrischen Leitungen in beiden Gehäuseteilen sichergestellt ist. Es wird ebenfalls die Gefahr des Einklemmens der elektrischen Leitungen beim Verbinden der beiden Gehäuseteile vermieden.

So ist es von Vorteil, wenn das Gehäuseoberteil an seinen unteren Seitenflächen Führungsnuten aufweist, die mit mindestens einem an den Seitenrändern des Gehäuseunterteils angeordneten Führungsprofil in Eingriff bringbar sind.

Hierdurch können die beiden Gehäuseteile geführt miteinander verbunden werden, so daß immer eine richtige Zuordnung der Buchsen und der Steckverbinder gewährleistet ist.

Gemäß einer weiteren vorteilhaften Ausgestaltung der Erfindung ist vorgesehen, daß in den Führungsnuten Aussparungen vorgesehen sind, in die das Führungsprofil zur Verriegelung des Gehäuseoberteils mit dem Gehäuseunterteil eingreift.

Auf diese Weise können Schrauben und ähnliches zum Verbinden der beiden Gehäuseteile entfallen. Eine derartige Verriegelung ist weniger zeitaufwendig und schließt Beschädigungen der Gehäuseteile, wie z.B. durch übermäßiges Anziehen der Schrauben, aus.

Wenn gemäß einer weiteren vorteilhaften Ausführungsform der Erfindung vorgesehen ist, daß das Führungsprofil als mindestens eine Rastfeder ausgebildet ist, ist ebenfalls eine problemlose Entriegelung der Gehäuseteile, z.B. zur Wartung oder Reparatur der Überwachungseinrichtung, möglich.

Zu diesem Zweck ist gemäß einer weiteren vorteilhaften Ausgestaltung der Erfindung vorgesehen, daß das Gehäuseoberteil im Bereich der Rastfeder eine Öffnung zur Entriegelung der beiden Gehäuseteile aufweist.

Zum Entriegeln wird durch die Öffnung ein Werkzeug, z.B. ein Schraubendreher, eingebracht, der die Rastfeder aus ihrer Entriegelungsstellung drückt.

Um ein unbefugtes Öffnen zu erschweren, ist die Öffnung an der geschlossenen Stirnseite des Gehäuseoberteils angeordnet. Hierdurch wird die Kraft nicht wie bei üblichen Rastverbindungen direkt senkrecht auf die Rastfeder, sondern von ihrer Längsrichtung her aufgebracht.

Ein Ausführungsbeispiel der Erfindung ist in der Zeichnung dargestellt und wird im folgenden näher beschrieben. Es zeigen:
- Fig. 1: eine perspektivische Explosionsansicht des Gehäuses; und
- Fig. 2: eine vergrößerte Teilansicht der Verriegelung des Gehäuses.

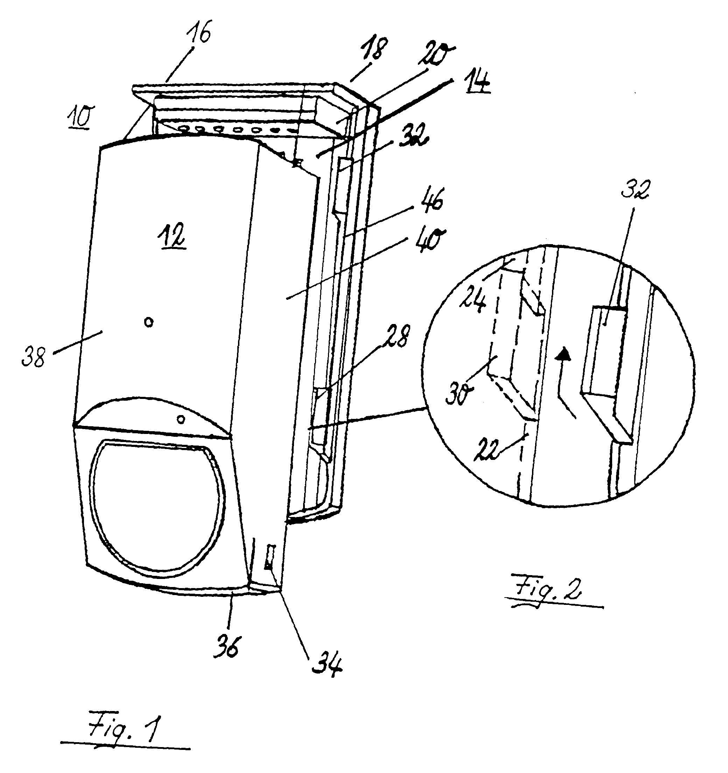

Das Gehäuse für eine Überwachungseinrichtung besteht gemäß Fig. 1 aus einem Gehäuseoberteil 12 und einem lösbar mit dem Gehäuseoberteil 12 über eine Verbindungseinrichtung zum Öffnen oder Schließen des Gehäuses verbindbaren Gehäuseunterteil 14. Die Verbindungseinrichtung besteht aus einer Geradführung mit einer Sicherung gegen Abheben, bevorzugt einer Schwalbenschwanzführung. Das Gehäuseoberteil 12 und das Gehäuseunterteil 14 sind jeweils mit einem Stiftelement bzw. einem Buchsenelement 20 eines elektrischen Steckverbinders versehen, die bezüglich der Steckrichtung parallel zur Geradführung ausgerichtet und ferner in der Weise relativ zueinander angeordnet sind, daß beim Schließen des Gehäuses mittels der Verbindungseinrichtung die elektrische Steckverbindung hergestellt wird.

Das in Fig. 1 dargestellte Gehäuseoberteil 12 und Gehäuseunterteil 14 haben hier im wesentlichen eine rechteckförmige Grundform. Das Gehäuseoberteil 12 ist kastenförmig mit U-förmigem Querschnitt mit einem im wesentlichen rechteckigen Deckenabschnitt 38 und mit zwei Seitenwänden 40 und einer an einem Ende angeordneten, die beiden Seitenwände 40 verbindenden Stirnwand 36 ausgebildet. Die am anderen Ende befindliche Stirnseite 36 ist offen. Das Gehäuseunterteil weist einen im wesentlichen rechteckigen Boden 46 sowie eine die stirnseitige Öffnung 16 des Gehäuseoberteils 12 abdeckende Stirnplatte 18 mit einem dem Inneren des Gehäuses 10 zugewandten Buchsenelement 20 zur Aufnahme mindestens eines im Gehäuseoberteil 12 angeordneten Steckverbinders (nicht dargestellt) beim Verbinden der Gehäuseteile 12, 14 auf.

Zum Zusammenbau des beschriebenen Gehäuses für eine Überwachungseinrichtung ist es nunmehr lediglich erforderlich, das Gehäuseoberteil 12 vor dem Gehäuseunterteil 14 anzuordnen und das Führungsprofil 28 mit den Führungsnuten 24 in den inneren Seitenflächen 22 des Gehäuseoberteils 12 in Eingriff zu bringen. Dann wird das Gehäuseoberteil 12 über das Gehäuseunterteil 14 geschoben, wobei die Steckverbinder mit dem Buchsenelement 20 in Eingriff treten und das Führungsprofil 28, z.B. in Form von Rastfedern 32, zur Verriegelung des Gehäuseoberteils 12 mit dem Gehäuseunterteil 14 in die Aussparungen 30 eingreift. Auf diese Weise ist eine schnelle, zuverlässige und sichere Montage der beiden Gehäuseteile sowie eine sichere Verbindung der elektrischen Schaltung mit den Sende- und/oder Empfangseinrichtungen gegeben.

## Patentansprüche

1. Gehäuse für eine Überwachungseinrichtung, bestehend aus einem Gehäuseoberteil (12) und einem lösbar mit dem Gehäuseoberteil (12) über eine Verbindungseinrichtung zum Öffnen oder Schließen des Gehäuses verbindbaren Gehäuseunterteil (14), wobei das Gehäuseoberteil (12) und das Gehäuseunterteil (14) jeweils mit einem Stiftelement bzw. einem Buchsenelement (20) eines elektrischen Steckverbinders versehen sind,
dadurch **gekennzeichnet,**
daß die Verbindungseinrichtung aus einer Schienen-Geradführung mit einer Sicherung gegen Abheben besteht, und daß das Stiftelement und das Buchsenelement (20) bezüglich der Steckrichtung parallel zur Schienen-Geradführung ausgerichtet und ferner in der Weise relativ zueinander angeordnet sind, daß beim Verschieben von Gehäuseoberteil (12) relativ zum Gehäuseunterteil (14) entlang der Schienen-Geradführung in die geschlossene Gehäusestellung die elektrische Steckverbindung hergestellt wird.

2. Gehäuse nach Anspruch 1,
dadurch **gekennzeichnet,**
daß die Schienen-Geradführung eine Schwalbenschwanzführung ist.

3. Gehäuse nach Anspruch 1 oder 2,
dadurch **gekennzeichnet,**
daß das Gehäuseoberteil (12) an zwei Seitenwänden (40) Führungsnuten (24) und das Gehäuseunterteil (14) an entsprechenden Seitenrändern ein Führungsprofil (28) zum Eingriff mit den Führungsnuten (24) aufweist.

4. Gehäuse nach einem der vorhergehenden Ansprüche,
dadurch **gekennzeichnet,**
daß eine Rastfeder (32) zur lösbaren Fixierung der Verbindungseinrichtung in der geschlossenen Gehäusestellung vorhanden ist.

5. Gehäuse nach Anspruch 4,
dadurch **gekennzeichnet,**
daß die Rastfeder (32) Teil des Führungsprofils (28) ist.

6. Gehäuse nach einem der Ansprüche 4 bis 5,
dadurch **gekennzeichnet,**
daß das Gehäuseoberteil (12) im Bereich der Rastfeder (32) eine Öffnung (34) zur Entriegelung der beiden Gehäuseteile (12, 14) aufweist.

7. Gehäuse nach Anspruch 6,
dadurch **gekennzeichnet,**
daß die Öffnung (34) an der geschlossenen Stirnseite (36) des Gehäuseoberteils (12) angeordnet ist.

8. Gehäuse nach einem der vorhergehenden Ansprüche,
dadurch **gekennzeichnet,**
daß das Gehäuseunterteil (14) eine eine stirnseitige Öffnung (16) des Gehäuseoberteils (12) abdeckende Stirnplatte (18) aufweist, an deren Innenseite das Buchsenelement (20) zur Aufnahme des im Gehäuseoberteil (12) angeordneten Stiftelements angeordnet ist.

## Claims

1. Housing for a surveillance device, comprising a housing top (12) and a housing bottom (14) detachably connected to the housing top (12) by means of a connecting device for opening or closing the housing, the housing top (12) and housing bottom (14) being in each case provided with a pin element or a socket element (20) of an electrical connector, characterized in that the connecting device comprises a rail straight guide with a removal preventer and that the pin element and the socket element (20) are oriented parallel to the rail guide with respect to the plug-in direction and are also mutually positioned in such a way that on sliding the housing top (12) relative to the housing bottom (14) along the rail guide an electrical plug connection is produced in the closed housing position.

2. Housing according to claim 1, characterized in that the rail guide is a dovetail guide.

3. Housing according to claim 1 or 2, characterized in that the housing top (12) has on two side walls (40) guide grooves (24) and the housing bottom (14) on the corresponding lateral edges a guide profile (28) for engagement with the guide grooves (24).

4. Housing according to one of the preceding claims, characterized in that a stop spring (32) is provided for the detachable fixing of the connecting device in the closed housing position.

5. Housing according to claim 4, characterized in that the stop spring (32) is part of the guide profile (28).

6. Housing according to one of the claims 4 or 5, characterized in that, in the vicinity of the stop spring (32), the housing top (12) has an opening (34) for unlocking the two housing parts (12, 14).

7. Housing according to claim 6, characterized in that the opening (34) is located on the closed face (36) of the housing top (12).

8. Housing according to one of the preceding claims, characterized in that the housing bottom (14) has a front plate (18) covering a front opening (16) of the housing top (12) and on whose inside is located the socket element (20) for receiving the pin element positioned in the housing top (12).

## Revendications

1. Boîtier pour un dispositif de surveillance, composé d'une partie supérieure (12) de boîtier et d'une partie inférieure (14) de boîtier pouvant être reliée de manière amovible à la partie supérieure (12) de boîtier par l'intermédiaire d'un dispositif de liaison afin d'ouvrir ou de fermer le boîtier. la partie supérieure (12) du boîtier et la partie inférieure (14) du boîtier étant munies chacune d'un élément formant fiche ou d'un élément formant douille (20) d'une prise de branchement électrique, ***caractérisé en ce que*** le dispositif de liaison se compose d'un guidage à rail droit avec une sûreté contre le soulèvement, et ***en ce que*** l'élément formant fiche et l'élément formant douille (20) sont orientés parallèlement au guidage à rail droit en ce qui concerne la direction d'insertion et. de plus, sont agencés l'un par rapport à l'autre de telle manière qu'en cas de déplacement de la partie supérieure (12) du boîtier par rapport à la partie inférieure (14) du boîtier le long du guidage à rail droit dans la position fermée du boîtier, la liaison électrique est établie.

2. Boîtier selon la Revendication 1, ***caractérisé en ce que*** le guidage à rail droit est un guidage en queue d'aronde.

3. Boîtier selon la Revendication 1 ou 2, ***caractérisé en ce que*** la partie supérieure (12) du boîtier présente sur deux parois latérales (40) des rainures de guidage (24) et la partie inférieure (14) du boîtier présente sur des bords latéraux correspondants un profil de guidage (28) destiné à se mettre en prise avec les rainures de guidage (24).

4. Dispositif selon l'une quelconque des Revendications précédentes, ***caractérisé en ce qu'***un ressort à déclic (32) est prévu pour immobiliser de manière amovible le dispositif de liaison dans la position fermée du boîtier.

5. Dispositif selon la Revendication 4, ***caractérisé en ce que*** le ressort à déclic (32) fait partie du profil de guidage (28).

6. Boîtier selon l'une quelconque des Revendications 4 à 5, ***caractérisé en ce que*** la partie supérieure (12) du boîtier présente au niveau du ressort à déclic (32) une ouverture (34) afin de verrouiller les deux parties (12, 14) du boîtier.

7. Boîtier selon la Revendication 6, ***caractérisé en ce que*** l'ouverture (34) est placée sur la face frontale fermée (36) de la partie supérieure (12) du boîtier.

8. Boîtier selon l'une quelconque des Revendications précédentes, ***caractérisé en ce que*** la partie inférieure (14) du boîtier présente une plaque frontale (18) recouvrant une ouverture frontale (16) de la partie supérieure (12) du boîtier, plaque sur la face intérieure de laquelle est placé l'élément formant douille (20) afin de recevoir l'élément formant fiche placé dans la partie supérieure (12) du boîtier.
